# EUROPÄISCHE PATENTSCHRIFT

(11) **EP 3 508 034 B1**
(45) Veröffentlichungstag und Bekanntmachung des Hinweises auf die Patenterteilung: **30.12.2020**
(21) Anmeldenummer: 17800434.7
(22) Anmeldetag: 02.11.2017
(51) Int. Cl.: H05B 45/20, H01L 33/62, H01L 25/075

(54) **FARBMISCHENDE LED-BAUEINHEIT UND HERSTELLUNGSVERFAHREN HIERFÜR**
COLOUR-MIXING LED COMPONENT AND METHOD OF PRODUCTION THEREFOR
ÉLÉMENT À DEL À MÉLANGE DE COULEURS ET SON PROCÉDÉ DE FABRICATION

(30) Priorität: 18.11.2016 DE 102016122209
(43) Veröffentlichungstag der Anmeldung: 10.07.2019
(73) Patentinhaber: Vishay Semiconductor GmbH, 74072 Heilbronn (DE)
(72) Erfinder: GOTTLOB, Heinrich, 74226 Nordheim (DE); RETTENMEIER, Franz, 74366 Kirchheim am Neckar (DE)
(74) Vertreter: Manitz Finsterwald Patent- und Rechtsanwaltspartnerschaft mbB
(86) Internationale Anmeldenummer: PCT/EP2017/078057
(87) Internationale Veröffentlichungsnummer: WO 2018/091274

(56) Entgegenhaltungen:
- DE-A1- 19 814 495
- DE-A1-102008 028 654
- DE-A1-102008 059 468
- DE-A1-102012 018 760
- DE-A1-102012 101 818

## Beschreibung

Die Erfindung betrifft eine farbmischende LED-Baueinheit, die einen Träger und wenigstens drei auf dem Träger angeordnete Leuchtdioden aufweist (engl.: "light emitting diode", LED). Der Träger kann beispielsweise ein elektrisch nichtleitendes Trägersubstrat (z.B. eine Keramik oder ein Kunstharz umfassend) und darauf oder darin vorgesehene elektrische Leitungen (z.B. Leiterbahnen aus Metall) aufweisen. Die auf dem Träger angeordneten Leuchtdioden sind dazu ausgebildet, Licht in voneinander verschiedenen Farben, d.h. in voneinander verschiedenen Spektralbereichen, zu emittieren und hierdurch gemeinsam eine Ausgangsstrahlung zu erzeugen, die einer additiven Farbmischung entspricht. Bei einer solchen LED-Baueinheit können die wenigstens drei Leuchtdioden beispielsweise dazu ausgebildet sein, Licht in den Farben Rot, Grün und Blau zu emittieren und hierdurch gemeinsam eine Ausgangsstrahlung zu erzeugen, die zumindest im Wesentlichen als weißes Licht erscheint.

Anwendung finden derartige LED-Baueinheiten beispielsweise in den Gebieten der allgemeinen Beleuchtung, Automobil-Innenraumbeleuchtung oder Hintergrundbeleuchtung von Displays.

Herstellungsbedingt weist jede der Leuchtdioden eine individuelle Emissionscharakteristik auf (z.B. individuelle Wellenlängencharakteristik und/oder Lichtstärkecharakteristik). Dies bedeutet, dass mehrere Leuchtdioden desselben Farbtyps, die in verschiedenen gleichartigen LED-Baueinheiten verbaut sind, bei gleichen Betriebsbedingungen (z.B. gleiche angelegte Spannung und gleiche Temperatur) nicht unbedingt dieselbe Emissionscharakteristik aufweisen. Beispielsweise können die Leuchtdioden desselben Farbtyps sich hinsichtlich ihrer dominanten Wellenlänge, ihrer Schwerpunktswellenlänge oder ihrer Lichtstärke voneinander unterscheiden. Dies hat zur Folge, dass zwischen verschiedenen gleichartigen LED-Baueinheiten bei gleichen Betriebsbedingungen visuell wahrnehmbare Unterschiede zwischen den erzeugten Ausgangsstrahlungen bestehen können. Dies ist besonders unerwünscht, wenn mehrere gleichartige LED-Baueinheiten nebeneinander angeordnet sind und eine möglichst homogene Ausgangsstrahlung erzeugen sollen.

Es ist zwar möglich, die Leuchtdioden nach verschiedenen Parametern ihrer Emissionscharakteristik, wie etwa ihrer dominanten Wellenlänge, ihrer Schwerpunktswellenlänge oder ihrer Lichtstärke, zu klassifizieren. Die Leuchtdioden können also vom Hersteller bezüglich dieser verschiedenen Parameter getestet werden, wobei die jeweilige Leuchtdiode für jeden der verschiedenen Parameter einer von mehreren vorbestimmten Klassen zugeordnet wird. Somit können für die Herstellung von mehreren LED-Baueinheiten, die relativ zueinander die gleiche Ausgangsstrahlung erzeugen sollen, Leuchtdioden ausgewählt werden, die bezüglich der verschiedenen Parameter ihrer Emissionscharakteristik denselben Klassen zugeordnet sind, sodass die LED-Baueinheiten hinsichtlich ihrer Ausgangsstrahlung übereinstimmen. Ein derartiger Selektionsprozess erfordert jedoch einen unerwünscht hohen logistischen Aufwand, da eine große Anzahl von möglichen Kombinationen aus Parametern und Parameterklassen der Emissionscharakteristik berücksichtigt bzw. vorgehalten werden muss.

Die LED-Baueinheit umfasst für jede der Leuchtdioden einen jeweiligen elektrischen Treibereingang, um die Leuchtdioden unabhängig voneinander mit elektrischer Energie zu versorgen. Die Emissionscharakteristik der Leuchtdioden ist von der jeweiligen Energieversorgung abhängig. Somit kann durch Variieren der jeweiligen Energieversorgung an den Treibereingängen die Farbmischung der Ausgangsstrahlung eingestellt werden. Dies kann beispielsweise erwünscht sein, um bei Verwendung der LED-Baueinheit als Beleuchtungsvorrichtung eine auswählbare Farbtemperatur einzustellen.

Diese Möglichkeit einer individuellen Energieversorgung der einzelnen Leuchtdioden der LED-Baueinheit kann auch dazu genutzt werden, Unterschiede zwischen der individuellen Emissionscharakteristik mehrerer Leuchtdioden desselben Farbtyps relativ zueinander zu kompensieren, so dass durch eine angepasste Ansteuerung der einzelnen Leuchtdioden mehrere nebeneinander angeordnete gleichartige LED-Baueinheiten eine zumindest im Wesentlichen gleiche Ausgangsstrahlung erzeugen. Hierzu kann für eine jeweilige LED-Baueinheit eine Kalibriermessung dergestalt durchgeführt werden, dass die in der LED-Baueinheit verwendeten Leuchtdioden hinsichtlich ihrer jeweiligen individuellen Emissionscharakteristik vermessen werden, wobei als Ergebnis der Kalibriermessung in einer Steuereinheit, die in der konkreten Anwendung mit der jeweiligen LED-Baueinheit verbunden wird, eine individuelle Ansteuerungscharakteristik gespeichert wird. Im Betrieb LED-Baueinheit steuert die Steuereinheit die Energieversorgung der einzelnen Leuchtdioden der LED-Baueinheit gemäß der gespeicherten Ansteuerungscharakteristik. Auf diese Weise kann also erreicht werden, dass mehrere LED-Baueinheiten hinsichtlich ihrer Ausgangsstrahlung übereinstimmen. Jedoch bedeutet auch diese Vorgehensweise einen unerwünscht hohen Aufwand seitens des Benutzers, insbesondere um die individuelle Ansteuerungscharakteristik auf einfache und fehlersichere Weise der jeweiligen Steuereinheit zuzuführen.

Die DE 10 2012 101818 A1 beschreibt ein optoelektronisches Modul, das über mindestens zwei Halbleiter mischfarbiges Licht erzeugen kann und das ein Bauelement zur Kodierung mindestens eines optischen oder elektronischen Parameters des Moduls aufweist.

Die DE 10 2008 028 654 A1 beschreibt ein Lichtmodul mit Leuchtdiodenchips, einem Speicherchip, einem berührungslos auslesbaren Transponder und einer Antenne. Der Speicherchip kann elektrische oder optische Parameter des Moduls speichern.

Die DE 10 2008 059 468 A1 beschreibt eine optoelektronische Lampe mit einer LED-Einheit und einem Kodierelement.

Die DE 198 14 495 A1 beschreibt eine Leuchtdiode mit einer elektrischen Kodierung ihrer Lichtstärkenklasse.

Die DE 10 2012 018 760 A1 beschreibt eine Vorrichtung zum Betreiben von LEDs, die die drei Farben eines RGB-Moduls von jeweiligen Treiber-Modulen ansteuert, die über jeweilige PWM-Kanäle angesteuert werden.

Es ist eine Aufgabe der Erfindung, eine LED-Baueinheit und ein Herstellungsverfahren für eine LED-Baueinheit zu schaffen, die für den Benutzer eine vereinfachte Berücksichtigung der individuellen Emissionscharakteristik der einzelnen Leuchtdioden ermöglichen, um die jeweilige LED-Baueinheit zum Erzeugen einer gewünschten Ausgangsstrahlung ansteuern zu können.

Diese Aufgabe wird mit den Merkmalen der unabhängigen Ansprüche gelöst.

Eine LED-Baueinheit weist die Merkmale des Anspruchs 1 auf. Eines der Merkmale ist ein Kalibrierinformationselement, das für jede der Leuchtdioden wenigstens einen auslesbaren Kalibrierwert enthält, der die individuelle Emissionscharakteristik der jeweiligen Leuchtdiode repräsentiert.

Die LED-Baueinheit ist mit wenigstens einem Kalibrierinformationselement versehen, welches in einer auslesbaren Weise eine Kalibrierinformation über die jeweilige individuelle Emissionscharakteristik der verschiedenen Leuchtdioden der LED-Baueinheit enthält. Der Benutzer der LED-Baueinheit kann die Kalibrierinformation auslesen und gemäß einer einfachen Rechenvorschrift in eine Ansteuerungscharakteristik umrechnen, gemäß derer die LED-Baueinheit in ihrem Betrieb angesteuert wird, um eine Ausgangsstrahlung mit einer erwünschten Farbmischung zu erzeugen. Im Betrieb der LED-Baueinheit steuert die Steuereinheit die Energieversorgung der einzelnen Leuchtdioden der LED-Baueinheit gemäß der gespeicherten Ansteuerungscharakteristik. Hierdurch kann die jeweilige individuelle Emissionscharakteristik der einzelnen Leuchtdioden auf einfache Weise berücksichtigt werden. Insbesondere kann vorgesehen sein, dass der Benutzer die in dem Kalibrierinformationselement enthaltene Information erst dann ausliest und in einer der LED-Baueinheit zugeordneten Steuereinheit speichert, zu dem die LED-Baueinheit und die zugeordnete Steuereinheit bereits zu einer Baugruppe dauerhaft vereinigt worden sind (beispielsweise durch Montage an einer gemeinsamen Trägereinrichtung und durch elektrische Verbindung miteinander).

Seitens des Herstellers der LED-Baueinheit kann die in dem Kalibrierinformationselement zu kodierende Kalibrierinformation der einzelnen Leuchtdioden entweder vor oder nach dem Montieren der Leuchtdioden an dem Träger der LED-Baueinheit ermittelt werden, wobei der logistische Aufwand verringert ist, wenn die Kalibriermessung erst durchgeführt wird, nachdem die Leuchtdioden bereits zu einer festen Einheit vereinigt worden sind. In jedem Falle umfasst die in dem Kalibrierinformationselement enthaltene Information für jede der Leuchtdioden der LED-Baueinheit wenigstens einen Kalibrierwert enthält, der die individuelle Emissionscharakteristik der jeweiligen Leuchtdiode repräsentiert. Dieser wenigstens eine Kalibrierwert kann gemäß einem vorbestimmten Schema für verschiedene Parametern der individuellen Emissionscharakteristik einen Messwert der Kalibriermessung oder einen hieraus abgeleiteten Klassenwert umfassen. Je nach Art des Kalibrierinformationselements kann dieses eine hohe Informationsdichte aufweisen, sodass die individuelle Emissionscharakteristik der Leuchtdioden mit entsprechend hoher Genauigkeit kodiert werden kann.

Nachfolgend werden vorteilhafte Ausführungsformen erläutert.

Gemäß einer Ausführungsform kann der in dem Kalibrierinformationselement enthaltene jeweilige Kalibrierwert den Wert der dominanten Wellenlänge, den Wert der Schwerpunktswellenlänge, und/oder den Wert der Lichtstärke der jeweiligen Leuchtdiode bei einem vorbestimmten Wert der Energieversorgung (z.B. an dem jeweiligen Treibereingang angelegte elektrische Spannung oder Stromstärke) repräsentieren.

Die genannten Werte der Emissionscharakteristik können ferner für verschiedene Werte der Energieversorgung (z.B. für verschiedene Spannungswerte) in dem Kalibrierinformationselement enthalten sein.

Ferner können in dem Kalibrierinformationselement für die jeweilige Leuchtdiode mehrere Kalibrierwerte für verschiedene sonstige Betriebsbedingungen (wie beispielsweise Temperatur) enthalten sein.

Der in dem Kalibrierinformationselement enthaltene wenigstens eine Kalibrierwert kann insbesondere eine Kennlinie oder ein Kennlinienfeld definieren.

Der jeweilige Kalibrierwert kann, wie bereits erwähnt, einen konkreten Messwert der zugrunde liegenden Kalibriermessung umfassen. Alternativ hierzu, nämlich wenn für den jeweiligen Parameter der Emissionscharakteristik ein Klassenschema definiert ist, kann der Kalibrierwert einen von einer vorbestimmten Vielzahl von möglichen Klassenwerten umfassen.

Gemäß einer Ausführungsform kann das Kalibrierinformationselement an einer Oberfläche des Trägers der LED-Baueinheit angeordnet sein. Hierdurch ist das Kalibrierinformationselement an der LED-Baueinheit leicht anbringbar und dennoch für das Auslesen gut zugänglich.

Vorzugsweise ist das Kalibrierinformationselement an einer Oberseite der LED-Baueinheit angeordnet, welche insbesondere derjenigen Seite der LED-Baueinheit entspricht, an der auch die Leuchtdioden angeordnet sind und das Licht emittieren. Hierdurch ist das Kalibrierinformationselement gut zugänglich und kann leicht ausgelesen werden, auch wenn die LED-Baueinheit und die zugeordnete Steuereinheit bereits zu einer Baugruppe dauerhaft vereinigt worden sind oder wenn mehrere LED-Baueinheiten nebeneinander angeordnet sind.

Das Kalibrierinformationselement ist optisch auslesbar. Hierdurch wird ein einfaches berührungsloses Auslesen mittels eines gängigen Verfahrens ermöglicht (z.B. Kamera mit Bildauswerteeinrichtung).

Insbesondere kann das Kalibrierinformationselement einen eindimensionalen optischen Code (z.B. Barcode) oder einen zweidimensionalen optischen Code (z.B. sogenannter "QR-Code"; eingetragene Marke) umfassen. Derartige eindimensionale oder zweidimensionale optische Codes ermöglichen eine hohe Informationsdichte und sind selbst bei geringen geometrischen Abmessungen zuverlässig auslesbar.

Das optisch auslesbare Kalibrierinformationselement muss allerdings nicht zwingend ein Codeelement umfassen, sondern kann auch wenigstens eine Ziffer, wenigstens einen Buchstaben oder eine Kombination aus wenigstens einer Ziffer und wenigstens einem Buchstaben umfassen. Diese Ausführungsform hat den Vorteil, dass die jeweilige Kalibrierinformation auch ohne einen maschinellen Codeleser ausgelesen werden kann, wobei gleichwohl ein maschinelles Auslesen möglich ist (durch Bilderkennung).

Das optisch auslesbare Kalibrierinformationselement ist durch Lasergravur gebildet. Eine derartige Lasergravur kann im Rahmen des Herstellungsprozesses der LED-Baueinheit bzw. entlang einer Fertigungslinie auf einfache Weise zu einem Zeitpunkt an der LED-Baueinheit angebracht werden, zu dem die Kalibrierinformation (aufgrund einer vorhergehenden Kalibriermessung) vorliegt und eine für die Anbringung der Lasergravur geeignete Oberfläche der LED-Baueinheit (insbesondere des Trägers) freiliegt und zugänglich ist.

Versuche haben gezeigt, dass ein Kalibrierinformationselement in Form eines durch Lasergravur angebrachten zweidimensionalen optischen Codes auch bei einer Größe von lediglich ca. 0,3 mm x 0,3 mm zuverlässig erkannt und optisch ausgelesen werden kann.

Gemäß einer Ausführungsform kann die LED-Baueinheit drei, vier, fünf oder sechs auf dem Träger angeordnete Leuchtdioden umfassen. Die LED-Baueinheit umfasst wenigstens drei Leuchtdioden, die unterschiedliche Emissionscharakteristiken (insbesondere unterschiedliche Wellenlängencharakteristiken) aufweisen, um durch Emission von Licht in unterschiedlichen Farben eine additive Farbmischung zu ermöglichen. Allerdings können auch mehr als drei Leuchtdioden vorgesehen sein, um die Möglichkeit der additiven Farbmischung zu erweitern und/oder um bezüglich einzelner Farben eine Redundanz oder eine erweiterte geometrische Verteilung zu schaffen.

Wie bereits erwähnt, können die wenigstens drei Leuchtdioden dazu ausgebildet sein, Licht in den Farben Rot, Grün und Blau zu emittieren und hierdurch gemeinsam eine als weißes Licht erscheinende Ausgangsstrahlung zu erzeugen.

Gemäß einer Ausführungsform kann die LED-Baueinheit einen Reflektor aufweisen, um das von den einzelnen Leuchtdioden emittierte Licht bzw. die von der LED-Baueinheit erzeugte Ausgangsstrahlung gemäß einer erwünschten geometrischen Charakteristik zu formen. Alternativ oder zusätzlich kann die LED-Baueinheit einen Diffusor aufweisen, um das von den einzelnen Leuchtdioden emittierte Licht möglichst effizient zu mischen.

Die genannten Treibereingänge für die elektrische Energieversorgung (z.B. Versorgungsspannung) der einzelnen Leuchtdioden können beispielsweise an einem seitlichen Bereich der LED-Baueinheit bzw. des Trägers vorgesehen sein. Für jeden Treibereingang kann ein eigener zugeordneter Masseanschluss vorgesehen sein, oder für sämtliche Treibereingänge der LED-Baueinheit ist ein gemeinsamer Masseanschluss vorhanden.

Bei der LED-Baueinheit handelt es sich um eine optoelektronische Komponente. Insbesondere kann es sich um ein oberflächenmontiertes Bauelement handeln (SMD; engl.: "surface mounted device"). Die LED-Baueinheit kann eine standardisierte Gehäuseform aufweisen, beispielsweise SMD PLCC-4 oder SMD PLCC-6. Die Abmessungen des Umrisses (Länge x Breite) betragen vorzugsweise maximal ca. 6 mm x 5 mm, beispielsweise ca. 3,2 mm x 2,8 mm oder ca. 3,5 mm x 2,2 mm. Die Höhe beträgt vorzugsweise maximal ca. 3 mm, beispielsweise ca. 1,9 mm oder ca. 1,5 mm.

Die Aufgabe der Erfindung wird auch durch ein Herstellungsverfahren mit den Merkmalen des unabhängigen Verfahrensanspruchs gelöst, und insbesondere durch ein Verfahren zum Herstellen einer farbmischenden LED-Baueinheit mit den folgenden Schritten:
- Bereitstellen eines Trägers;
- Bereitstellen von wenigstens drei Leuchtdioden, die dazu ausgebildet sind, Licht in voneinander verschiedenen Farben zu emittieren, und deren jeweilige Emissionscharakteristik von ihrer Energieversorgung abhängig ist;
- Anordnen der Leuchtdioden auf dem Träger dergestalt, dass die von den Leuchtdioden emittierten verschiedenen Farben gemeinsam eine Ausgangsstrahlung ergeben, die einer additiven Farbmischung entspricht, und dass die Leuchtdioden über einen jeweiligen Treibereingang separat mit elektrischer Energie versorgbar sind;
- Durchführen einer Kalibriermessung, um für jede der Leuchtdioden wenigstens einen Kalibrierwert zu ermitteln, der eine individuellen Emissionscharakteristik der jeweiligen Leuchtdiode repräsentiert; und
- mittels Lasergravur Versehen des Trägers mit einem optisch lesbaren Kalibrierinformationselement, das für jede der Leuchtdioden den ermittelten Kalibrierwert in einer auslesbaren Form enthält.

Die verschiedenen Verfahrensschritte müssen nicht unbedingt in der genannten Reihenfolge ausgeführt werden. Beispielsweise kann das Durchführen der Kalibriermessung erfolgen, bevor oder (bevorzugt) nachdem die Leuchtdioden auf dem Träger angeordnet worden sind. Je nach Art des Kalibrierinformationselements kann der Träger mit dem Kalibrierinformationselement versehen werden, bevor die Kalibrierwerte ermittelt worden sind oder in das Kalibrierinformationselement aufgenommen worden sind (z.B. wenn es sich bei dem Kalibrierinformationselement um einen elektrischen Speicher handelt), oder nachdem die Kalibrierwerte ermittelt worden sind (z.B. wenn das Kalibrierinformationselement als optischer Code angebracht wird).

Das Durchführen der Kalibriermessung kann insbesondere die folgenden Schritte umfassen:
- Versorgen der jeweiligen Leuchtdiode mit wenigstens einem vorbestimmten Wert einer elektrischen Energie (z.B. Spannungswert) und Messen wenigstens eines zugeordneten Werts der individuellen Emissionscharakteristik der jeweiligen Leuchtdiode (z.B. Wert der dominanten Wellenlänge); und
- Auswählen des Kalibrierwerts in Abhängigkeit von dem gemessenen Wert der individuellen Emissionscharakteristik der jeweiligen Leuchtdiode.
Das Auswählen des Kalibrierwerts kann beispielsweise ein Zuordnen zu einem von mehreren Wertebereichen umfassen, die verschiedenen vorbestimmten Werteklassen entsprechen. Hierbei können mehrere verschiedene Parameter der individuellen Emissionscharakteristik und für jeden Parameter mehrere Parameterklassen vorgesehen sein.

Im Übrigen kann die im Zusammenhang mit dem Herstellungsverfahren genannte LED-Baueinheit die Merkmale der LED-Baueinheit gemäß den vorstehend erläuterten Ausführungsformen besitzen.

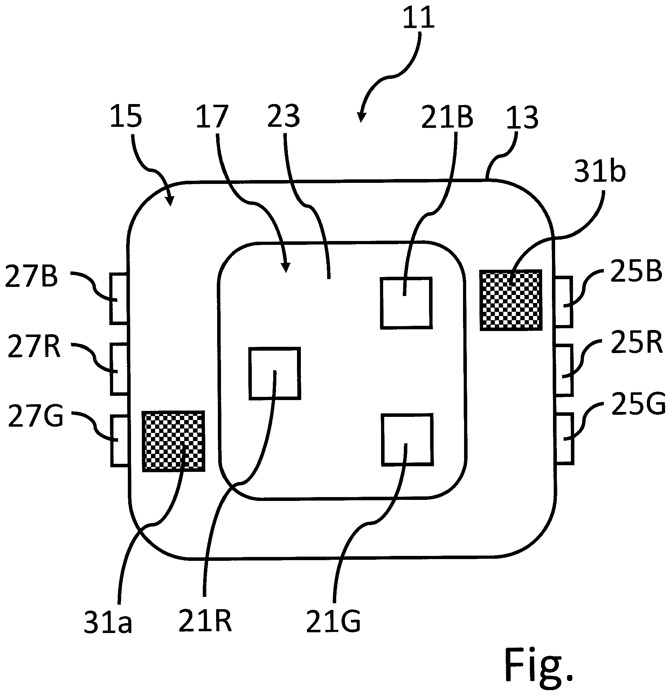

Die Erfindung wird nachfolgend lediglich beispielhaft unter Bezugnahme auf die Zeichnung erläutert.

Die einzige Figur zeigt eine farbmischende LED-Baueinheit 11 in einer Draufsicht. Die LED-Baueinheit 11 besitzt einen Träger 13 in Form eines Gehäuses, das an seiner Oberseite einen rahmenförmigen Randbereich 15 aufweist. Innerhalb des Randbereichs 15 befindet sich ein Montagebereich 17 des Trägers 13. In dem Montagebereich 17 sind drei Leuchtdioden 21R, 21G, 21B angeordnet. Die Leuchtdioden 21R, 21G, 21B sind dazu ausgebildet, Licht in den Farben bzw. Spektralbereichen Rot, Grün und Blau zu emittieren und hierdurch gemeinsam eine Ausgangsstrahlung zu erzeugen, die einer additiven Farbmischung entspricht und im Wesentlichen als weißes Licht erscheint. Das additive Mischen der drei Farben wird durch einen nicht näher gezeigten diffus-transparenten Diffusor 23 unterstützt, der die Leuchtdioden 21R, 21G, 21B überdeckt.

Um die Leuchtdioden 21R, 21G, 21B mit elektrischer Energie versorgen zu können, weist die LED-Baueinheit 11 eine entsprechende Anzahl von Treibereingängen und zugehörigen Masseanschlüsse auf, die als Kontaktelemente aus dem Träger 13 bzw. Gehäuse seitlich herausragen und sich zur Unterseite der LED-Baueinheit 11 (nicht gezeigt) erstrecken. Der Leuchtdiode 21R ist ein Treibereingang 25R mit Masseanschluss 27R zugeordnet. Der Leuchtdiode 21G ist ein Treibereingang 25G mit Masseanschluss 27G zugeordnet. Der Leuchtdiode 21B ist ein Treibereingang 25B mit Masseanschluss 27B zugeordnet. Die jeweilige Leuchtdiode 21R, 21G, 21B besitzt zwei Anschlüsse, die über elektrische Verbindungsleitungen des Trägers 13 (nicht gezeigt) mit dem jeweiligen Treibereingang 25R, 25G, 25B bzw. Masseanschluss 27R, 27G, 27B verbunden sind.

Herstellungsbedingt weist jede der Leuchtdioden 21R, 21G, 21B eine individuelle Emissionscharakteristik auf, insbesondere eine individuelle Wellenlängencharakteristik (Emissionsspektrum, d.h. relative Intensität in Abhängigkeit von der Wellenlänge) und eine individuelle Lichtstärkecharakteristik (Lichtstärke in der Einheit mcd). Beispielsweise können die Leuchtdioden 21R mehrerer verschiedener, jedoch gleichartiger LED-Baueinheiten 11 sich bei gleichen Betriebsbedingungen (z.B. gleiche angelegte Spannung und gleiche Temperatur) hinsichtlich ihrer dominanten Wellenlänge voneinander unterscheiden.

Die Emissionscharakteristik der Leuchtdioden 21R, 21G, 21B ist ferner von der jeweiligen Energieversorgung abhängig, also von der an den Treibereingängen 25R, 25G, 25B angelegten elektrischen Spannung und/oder Stromstärke. Diese Eigenschaft kann dazu genutzt werden, durch geeignete Anpassung der jeweiligen Energieversorgung an den Treibereingängen 25R, 25G, 25B die Farbmischung der Ausgangsstrahlung einzustellen und überdies die jeweilige individuelle Emissionscharakteristik der Leuchtdioden 21R, 21G, 21B zu berücksichtigen. Mit anderen Worten kann eine Abweichung der jeweiligen individuellen Emissionscharakteristik von einem Referenzwert kompensiert werden, indem die Energieversorgung der jeweiligen Leuchtdiode 21R, 21G, 21B erhöht oder verringert wird. Eine entsprechende Ansteuerung der Leuchtdioden 21R, 21G, 21B mittels einer zugeordneten Steuereinheit setzt allerdings voraus, dass zu jeder Leuchtdiode 21R, 21G, 21B der LED-Baueinheit 11 die individuelle Emissionscharakteristik bekannt ist.

Um eine derartige angepasste Ansteuerung der Leuchtdioden 21R, 21G, 21B zu vereinfachen, weist die LED-Baueinheit 11 zwei Kalibrierinformationselemente 31a, 31b auf, welche für jede der Leuchtdioden 21R, 21G, 21B einen auslesbaren Kalibrierwert enthalten, der die individuelle Emissionscharakteristik der jeweiligen Leuchtdiode 21R, 21G, 21B repräsentiert. Bei dem hier gezeigten Ausführungsbeispiel enthält das Kalibrierinformationselement 31a für jede der Leuchtdioden 21R, 21G, 21B einen ersten Kalibrierwert, der eine individuelle Wellenlängencharakteristik der jeweiligen Leuchtdiode 21R, 21G, 21B repräsentiert. Das Kalibrierinformationselement 31b enthält für jede der Leuchtdioden 21R, 21G, 21B einen zweiten Kalibrierwert, der eine individuelle Lichtstärkecharakteristik der jeweiligen Leuchtdiode 21R, 21G, 21B repräsentiert. Diese Kalibrierwerte können als physikalische Größen (z.B. als dominante Wellenlänge in der Einheit nm bzw. als Lichtstärke in der Einheit mcd), oder als Klassenwert gemäß einem vorbestimmten Klassenschema enthalten sein.

Die beiden Kalibrierinformationselemente 31a, 31b sind an der Oberseite des Trägers 13 bzw. Gehäuses innerhalb des rahmenförmigen Randbereichs 15 angeordnet. Die Kalibrierinformationselemente 31a, 31b sind durch einen jeweiligen zweidimensionalen optischen Code gebildet, der bei dem hier gezeigten Ausführungsbeispiel durch eine Lasergravur gebildet ist.

Die Kalibrierinformationselemente 31a, 31b sind somit auf einfache Weise, beispielsweise mittels einer Kamera, optisch auslesbar, um die darin enthaltene Kalibrierinformation, also die genannten Kalibrierwerte, zu erfassen. Das Auslesen der Kalibrierwerte und Speichern der ausgelesenen Kalibrierwerte in einer der jeweiligen LED-Baueinheit 11 zugeordneten Steuereinheit kann insbesondere bei der Montage einer Baugruppe erfolgen, welche eine oder mehrere LED-Baueinheiten) 11 und wenigstens eine zugeordneten Steuereinheit umfasst. Beispielsweise kann eine Kamera zum Auslesen der Kalibrierwerte aus den Kalibrierinformationselementen 31a, 31b entlang einer Fertigungslinie vorgesehen sein, in der eine Trägereinrichtung mit einer oder mehreren LED-Baueinheit(en) 11 und der zugeordneten Steuereinheit bestückt wird, wobei die ausgelesenen und ggf. dekodierten oder umgerechneten Kalibrierwerte der jeweiligen Leuchtdioden 21R, 21G, 21B in der zugeordneten Steuereinheit gespeichert werden, um eine individuelle Ansteuerungscharakteristik zu ermöglichen. Die zugeordnete Steuereinheit ist zu diesem Zeitpunkt vorzugsweise bereits fest mit der jeweiligen LED-Baueinheit 11 bzw. der gemeinsamen Trägereinrichtung verbunden, sodass der logistische Aufwand minimiert wird und Fehler durch Fehlzuordnungen (Verwechslungen zwischen verschiedenen Steuereinheiten) sicher vermieden werden können.

Das Ermitteln der Kalibrierinformation (entsprechend der individuellen Emissionscharakteristik) der einzelnen Leuchtdioden 21R, 21G, 21B kann durch entsprechende Kalibriermessung bei dem Hersteller der LED-Baueinheit 11 erfolgen, insbesondere nachdem die Leuchtdioden 21R, 21G, 21B bereits an dem Träger 13 der jeweiligen LED-Baueinheit 11 montiert worden sind. Für die Durchführung der Kalibriermessung kann die jeweiligen Leuchtdiode 21R, 21G, 21B mit einem vorbestimmten Wert einer elektrischen Energie (z.B. vorbestimmter Spannungswert) versorgt werden, wobei wenigstens ein zugeordneter Wert der individuellen Emissionscharakteristik der Leuchtdiode 21R, 21G, 21B (z.B. dominante Wellenlänge) gemessen wird. Nach Erfassen der jeweiligen Kalibrierinformation kann noch eine rechnerische Analyse und/oder Umwandlung erfolgen (z.B. Schwellwertvergleich oder Zuordnen des Messwerts zu einer von mehreren vorbestimmten Klassen). Der hieraus resultierende jeweilige Kalibrierwert wird in das Kalibrierinformationselement 31a, 31b der betreffenden LED-Baueinheit 11 aufgenommen, wobei bei dem hier beschriebenen Ausführungsbeispiel (zweidimensionaler optischer Code in Form einer Lasergravur) das Kalibrierinformationselement 31a, 31b erst dann an der betreffenden LED-Baueinheit 11 angebracht wird, wenn sämtliche darin enthaltene Kalibrierwerte ermittelt worden sind.

### Bezugszeichenliste

- 11: LED-Baueinheit
- 13: Träger
- 15: Randbereich
- 17: Montagebereich
- 21R, 21G, 21B: Leuchtdiode
- 23: Diffusor
- 25R, 25G, 25B: Treibereingang
- 27R, 27G, 27B: Masseanschluss
- 31a, 31b: Kalibrierinformationselement

## Patentansprüche

1. Farbmischende LED-Baueinheit (11), mit einem Träger (13) und wenigstens drei auf dem Träger (13) angeordneten Leuchtdioden (21R, 21G, 21B), die dazu ausgebildet sind, Licht in voneinander verschiedenen Farben zu emittieren und hierdurch gemeinsam eine Ausgangsstrahlung zu erzeugen, die einer additiven Farbmischung entspricht, wobei jede der Leuchtdioden (21R, 21G, 21B) eine individuelle Emissionscharakteristik aufweist, und mit einem jeweiligen Treibereingang (25R, 25G, 25B) für jede der Leuchtdioden (21R, 21G, 21B), um die Leuchtdioden (21R, 21G, 21B) mit elektrischer Energie zu versorgen, wobei die Emissionscharakteristik der Leuchtdioden (21R, 21G, 21B) von der jeweiligen Energieversorgung abhängig ist, so dass durch Variieren der jeweiligen Energieversorgung an den Treibereingängen (25R, 25G, 25B) die Farbmischung der Ausgangsstrahlung einstellbar ist,
wobei die LED-Baueinheit (11) ferner wenigstens ein Kalibrierinformationselement (31a, 31b) aufweist,
**dadurch gekennzeichnet, dass**
das Kalibrierinformationselement (31a, 31b)
i) für jede der Leuchtdioden (21R, 21G, 21B) wenigstens einen auslesbaren Kalibrierwert enthält, der die individuelle Emissionscharakteristik der jeweiligen Leuchtdiode (21R, 21G, 21B) repräsentiert,
ii) durch Lasergravur gebildet ist, und
iii) optisch auslesbar ist.

2. Farbmischende LED-Baueinheit (11) nach Anspruch 1,
wobei der Kalibrierwert
- den Wert der dominanten Wellenlänge,
- den Wert der Schwerpunktswellenlänge, und/oder
- den Wert der Lichtstärke
der jeweiligen Leuchtdiode (21R, 21G, 21B) bei einem vorbestimmten Wert der Energieversorgung repräsentiert.

3. Farbmischende LED-Baueinheit (11) nach Anspruch 1 oder 2,
wobei der Kalibrierwert einen von einer vorbestimmten Vielzahl von möglichen Klassenwerten umfasst.

4. Farbmischende LED-Baueinheit (11) nach einem der vorhergehenden Ansprüche,
wobei das Kalibrierinformationselement (31a, 31b) an einer Oberfläche des Trägers (13) angeordnet ist.

5. Farbmischende LED-Baueinheit (11) nach einem der vorhergehenden Ansprüche,
wobei das Kalibrierinformationselement (31a, 31b)an einer Oberseite der LED-Baueinheit (11) angeordnet ist.

6. Farbmischende LED-Baueinheit (11) nach Anspruch 1,
wobei das Kalibrierinformationselement (31a, 31b)einen eindimensionalen oder zweidimensionalen optischen Code umfasst.

7. Farbmischende LED-Baueinheit (11) nach einem der vorhergehenden Ansprüche,
wobei die LED-Baueinheit (11) drei, vier, fünf oder sechs auf dem Träger (13) angeordnete Leuchtdioden (21R, 21G, 21B) umfasst.

8. Farbmischende LED-Baueinheit (11) nach einem der vorhergehenden Ansprüche,
wobei die wenigstens drei Leuchtdioden (21R, 21G, 21B) dazu ausgebildet sind, Licht in den Farben Rot, Grün und Blau zu emittieren und hierdurch gemeinsam eine Ausgangsstrahlung zu erzeugen, die als weißes Licht erscheint.

9. Farbmischende LED-Baueinheit (11) nach einem der vorhergehenden Ansprüche,
wobei die LED-Baueinheit (11) ferner einen Reflektor und/oder einen Diffusor (23) aufweist.

10. Verfahren zum Herstellen einer farbmischenden LED-Baueinheit (11), mit den folgenden Schritten:
- Bereitstellen eines Trägers (13);
- Bereitstellen von wenigstens drei Leuchtdioden (21R, 21G, 21B), die dazu ausgebildet sind, Licht in voneinander verschiedenen Farben zu emittieren, und deren jeweilige Emissionscharakteristik von ihrer Energieversorgung abhängig ist;
- Anordnen der Leuchtdioden (21R, 21G, 21B) auf dem Träger (13) dergestalt, dass die von den Leuchtdioden (21R, 21G, 21B) emittierten verschiedenen Farben gemeinsam eine Ausgangsstrahlung ergeben, die einer additiven Farbmischung entspricht, und dass die Leuchtdioden (21R, 21G, 21B) über einen jeweiligen Treibereingang (25R, 25G, 25B) separat mit elektrischer Energie versorgbar sind;
**gekennzeichnet durch** die Schritte
- Durchführen einer Kalibriermessung, um für jede der Leuchtdioden (21R, 21G, 21B) wenigstens einen Kalibrierwert zu ermitteln, der eine individuelle Emissionscharakteristik der jeweiligen Leuchtdiode (21R, 21G, 21B) repräsentiert; und
- durch Lasergravur Versehen des Trägers (13) mit einem Kalibrierinformationselement (31a, 31b), das für jede der Leuchtdioden (21R, 21G, 21B) den ermittelten Kalibrierwert in einer optisch auslesbaren Form enthält.

11. Verfahren nach Anspruch 10,
wobei das Durchführen der Kalibriermessung umfasst:
- Versorgen der jeweiligen Leuchtdiode (21R, 21G, 21B) mit wenigstens einem vorbestimmten Wert einer elektrischen Energie und Messen wenigstens eines zugeordneten Werts der individuellen Emissionscharakteristik der jeweiligen Leuchtdiode (21R, 21G, 21B); und
- Auswählen des Kalibrierwerts in Abhängigkeit von dem gemessenen Wert der individuellen Emissionscharakteristik der jeweiligen Leuchtdiode (21R, 21G, 21B).

## Claims

1. A color mixing LED assembly (11) having a carrier (13) and at least three light emitting diodes (21R, 21G, 21B) which are arranged on the carrier (13) and which are configured to emit light in mutually different colors and hereby to together generate an output radiation which corresponds to an additive color mix, wherein each of the light emitting diodes (21R, 21G, 21B) has an individual emission characteristic; and having a respective driver input (25R, 25G, 25B) for each of the light emitting diodes (21R, 21G, 21B) to supply the light emitting diodes (21R, 21G, 21B) with electrical energy; wherein the emission characteristics of the light emitting diodes (21R, 21G, 21B) are dependent on the respective energy supply so that the color mix of the output radiation can be set by varying the respective energy supply at the driver inputs (25R, 25G, 25B); and
wherein the LED assembly (11) furthermore has at least one calibration information element (31a, 31b),
**characterized in that**
the calibration information element (31a, 31b)
i) includes at least one readable calibration value for each of the light emitting diodes (21R, 21G, 21B) that represents the individual emission characteristic of the respective light emitting diode (21R, 21G, 21B),
ii) is formed by a laser engraving and
iii) is optically readable.

2. A color mixing LED assembly (11) in accordance with claim 1,
wherein the calibration value represents
- the value of the dominant wavelength;
- the value of the spectral centroid; and/or
- the value of the luminous intensity
of the respective light emitting diode (21R, 21G, 21B) at a predefined value of the energy supply.

3. A color mixing LED assembly (11) in accordance with claim 1 or claim 2,
wherein the calibration value comprises one of a predefined plurality of possible class values.

4. A color mixing LED assembly (11) in accordance with any one of the preceding claims,
wherein the calibration information element (31a, 31b)is arranged at a surface of the carrier (13).

5. A color mixing LED assembly (11) in accordance with any one of the preceding claims,
wherein the calibration information element (31a, 31b)is arranged at a top side of the LED assembly (11).

6. A color mixing LED assembly (11) in accordance with claim 1,
wherein the calibration information element (31a, 31b)comprises a one-dimensional or two-dimensional optical code.

7. A color mixing LED assembly (11) in accordance with any one of the preceding claims,
wherein the LED assembly (11) comprises three, four, five, or six light emitting diodes (21R, 21G, 21B) arranged on the carrier (13).

8. A color mixing LED assembly (11) in accordance with any one of the preceding claims,
wherein the at least three light emitting diodes (21R, 21G, 21B) are configured to emit light in the colors red, green, and blue and hereby to together generate an output radiation which appears as white light.

9. A color mixing LED assembly (11) in accordance with any one of the preceding claims,
wherein the LED assembly (11) furthermore has a reflector and/or a diffuser (23).

10. A method of manufacturing a color mixing LED assembly (11) comprising the following steps:
- providing a carrier (13);
- providing at least three light emitting diodes (21R, 21G, 21B) which are configured to emit light in mutually different colors and whose respective emission characteristics are dependent on their energy supply;
- arranging the light emitting diodes (21R, 21G, 21B) on the carrier (13) such that the different colors emitted by the light emitting diodes (21R, 21G, 21B) together generate an output radiation which corresponds to an additive color mix and such that the light emitting diodes (21R, 21G, 21B) can be separately supplied with electrical energy via a respective driver input (25R, 25G, 25B),
**characterized by** the steps
- carrying out a calibration measurement to determine at least one calibration value for each of the light emitting diodes (21R, 21G, 21B) that represents an individual emission characteristic of the respective light emitting diode (21R, 21G, 21B); and
- providing the carrier (13) with a calibration information element (31a, 31b)by laser engraving, said calibration information element (31a, 31b) including the determined calibration value for each of the light emitting diodes (21R, 21G, 21B) in an optically readable form.

11. A method in accordance with claim 10,
wherein the carrying out of the calibration measurement comprises:
- supplying the respective light emitting diode (21R, 21G, 21B) with at least one predefined value of electrical energy and measuring at least one associated value of the individual emission characteristic of the respective light emitting diode (21R, 21G, 21B); and
- selecting the calibration value in dependence on the measured value of the individual emission characteristic of the respective light emitting diode (21R, 21G, 21B).

## Revendications

1. Unité structurelle à DEL à mélange de couleurs (11), comprenant un support (13) et au moins trois diodes électroluminescentes (21R, 21G, 21B) disposées sur le support (13) et réalisées pour émettre de la lumière de couleurs qui diffèrent les unes des autres et pour générer ainsi conjointement un rayonnement de sortie qui correspond à un mélange additif de couleurs, chacune des diodes électroluminescentes (21 R, 21G, 21B) ayant une caractéristique d'émission individuelle, et comprenant une entrée de commande respective (25R, 25G, 25B) pour chacune des diodes électroluminescentes (21R, 21G, 21B) afin d'alimenter les diodes électroluminescentes (21R, 21G, 21B) en énergie électrique, la caractéristique d'émission des diodes électroluminescentes (21R, 21G, 21B) étant dépendante de l'alimentation en énergie respective, de sorte que le mélange de couleurs du rayonnement de sortie peut être réglé en faisant varier l'alimentation en énergie respective aux entrées de commande (25R, 25G, 25B),
l'unité structurelle à DEL (11) comprenant en outre au moins un élément d'information de calibrage (31a, 31b),
**caractérisée en ce que**
l'élément d'information de calibrage (31a, 31b)
i) comprend au moins une valeur de calibrage lisible pour chacune des diodes électroluminescentes (21R, 21G, 21B), valeur qui représente la caractéristique d'émission individuelle de la diode électroluminescente respective (21R, 21G, 21B),
ii) est formé par gravure au laser, et
iii) est lisible par voie optique.

2. Unité structurelle à DEL à mélange de couleurs (11) selon la revendication 1,
dans laquelle la valeur de calibrage représente
- la valeur de la longueur d'onde dominante,
- la valeur de la longueur d'onde d'intensité, et/ou
- la valeur de l'intensité lumineuse
de la diode électroluminescente respective (21R, 21G, 21B) à une valeur prédéterminée de l'alimentation en énergie.

3. Unité structurelle à DEL à mélange de couleurs (11) selon la revendication 1 ou 2,
dans laquelle la valeur de calibrage comprend une valeur parmi une multitude prédéterminée de valeurs de classe possibles.

4. Unité structurelle à DEL à mélange de couleurs (11) selon à l'une des revendications précédentes,
dans laquelle l'élément d'information de calibrage (31a, 31b)est disposé sur une surface du support (13).

5. Unité structurelle à DEL à mélange de couleurs (11) selon à l'une des revendications précédentes,
dans laquelle l'élément d'information de calibrage (31a, 31b) est disposé sur une face supérieure de l'unité structurelle à DEL (11).

6. Unité structurelle à DEL à mélange de couleurs (11) selon la revendication 1,
dans laquelle l'élément d'information de calibrage (31a, 31b) comprend un code optique unidimensionnel ou bidimensionnel.

7. Unité structurelle à DEL à mélange de couleurs (11) selon l'une des revendications précédentes,
dans laquelle l'unité structurelle à DEL (11) comprend trois, quatre, cinq ou six diodes électroluminescentes (21R, 21G, 21B) disposées sur le support (13).

8. Unité structurelle à DEL à de mélange de couleurs (11) selon l'une des revendications précédentes,
dans laquelle lesdites au moins trois diodes électroluminescentes (21R, 21G, 21B) sont réalisées pour émettre de la lumière dans les couleurs rouge, verte et bleue et pour ainsi générer conjointement un rayonnement de sortie qui apparaît comme de la lumière blanche.

9. Unité structurelle à DEL à mélange de couleurs (11) selon l'une des revendications précédentes,
dans laquelle l'unité structurelle à DEL (11) comprend en outre un réflecteur et/ou un diffuseur (23).

10. Procédé de réalisation d'une unité structurelle à DEL à mélange de couleurs (11), comprenant les étapes suivantes consistant à :
- fournir un support (13) ;
- fournir au moins trois diodes électroluminescentes (21R, 21G, 21B) qui sont réalisées pour émettre de la lumière de couleurs qui diffèrent les unes des autres, et dont la caractéristique d'émission respective dépend de leur alimentation en énergie ;
- disposer les diodes électroluminescentes (21R, 21G, 21B) sur le support (13) de telle sorte que les différentes couleurs émises par les diodes électroluminescentes (21R, 21G, 21B) génèrent conjointement un rayonnement de sortie qui correspond à un mélange additif de couleurs, et de telle sorte que les diodes électroluminescentes (21R, 21G, 21B) peuvent être alimentées séparément en énergie électrique par une entrée de commande respective (25R, 25G, 25B) ;
**caractérisé par** les étapes consistant à :
- réaliser une mesure de calibrage, afin de déterminer pour chacune des diodes électroluminescentes (21R, 21G, 21B) au moins une valeur de calibrage qui représente une caractéristique d'émission individuelle de la diode électroluminescente respective (21R, 21G, 21B) ; et
- équiper le support (13) d'un élément d'information de calibrage (31a, 31b) par gravure au laser, élément qui contient la valeur de calibrage déterminée sous une forme lisible par voie optique pour chacune des diodes électroluminescentes (21R, 21G, 21B).

11. Procédé selon la revendication 10,
dans lequel la réalisation de la mesure de calibrage consiste à
- alimenter la diode électroluminescente respective (21R, 21G, 21B) avec au moins une valeur prédéterminée d'une énergie électrique et mesurer au moins une valeur associée de la caractéristique d'émission individuelle de la diode électroluminescente respective (21R, 21G, 21B) ; et
- sélectionner la valeur de calibrage en fonction de la valeur mesurée de la caractéristique d'émission individuelle de la diode électroluminescente respective (21R, 21G, 21B).
